# DEMANDE DE BREVET EUROPEEN

(11) **EP 4 502 715 A1**
(43) Date de publication de la demande: **05.02.2025**
(21) Numéro de dépôt: 24190842.5
(22) Date de dépôt: 25.07.2024
(51) Int. Cl.: G02F 1/025, H10N 70/20

(54) **COMMUTATEUR À BASE DE MATÉRIAU À CHANGEMENT DE PHASE**

(30) Priorité: 03.08.2023 FR 2308452
(71) Demandeur: Commissariat à l'Energie Atomique et aux Energies Alternatives, 75015 Paris (FR); Institut Polytechnique de Grenoble, 38000 Grenoble (FR); Université Grenoble Alpes, 38400 Saint-Martin-d'Hères (FR)
(72) Inventeur: REIG, Bruno, 38054 GRENOBLE CEDEX 09 (FR); HELLION, Clémence, 38054 GRENOBLE CEDEX 09 (FR); CHARLET, Ismaël, 38054 GRENOBLE CEDEX 09 (FR); ALLAIN, Marjolaine, 38054 GRENOBLE CEDEX 09 (FR); NAOUI, Ayoub, 38000 GRENOBLE (FR)
(74) Mandataire: Cabinet Beaumont

(57) **Abrégé**

La présente description concerne un commutateur (100) à base d'un matériau à changement de phase formé sur un substrat de support (101) et comprenant :
- une région (107) en ledit matériau à changement de phase reliant des première et deuxième électrodes de conduction (105A, 105B) du commutateur ; et
- un guide d'ondes (111) interposé entre le substrat de support et la région en ledit matériau à changement de phase et comportant une région centrale (111C) en un premier matériau présentant un premier indice optique entourée d'une région périphérique (103) en un deuxième matériau présentant un deuxième indice optique, inférieur au premier indice optique.

## Description

### Domaine technique

La présente description concerne de façon générale les dispositifs électroniques, en particulier les commutateurs. La présente description concerne plus particulièrement les commutateurs à base de matériau à changement de phase.

### Technique antérieure

Diverses applications utilisent des commutateurs pour interrompre ou autoriser, en fonction de l'état d'un signal de commande du commutateur, le passage d'un signal électrique entre différentes parties d'un circuit électronique. Dans le domaine des télécommunications, des commutateurs de signaux radiofréquence, également appelés commutateurs radiofréquence (RF), sont intégrés dans divers types de dispositifs tels que des filtres reconfigurables, des déphaseurs, des antennes reconfigurables à réseau transmetteur ou à réseau réflecteur, etc. Ces commutateurs permettent notamment de mettre en oeuvre diverses fonctions : routage de signaux RF, commutation d'une antenne entre des modes d'émission et de réception, activation d'un filtre correspondant à une bande de fréquences donnée, etc. Les commutateurs RF trouvent en particulier leur utilité dans la conception et la réalisation de surfaces rayonnantes reconfigurables dans les bandes de fréquences sub-térahertz, par exemple de l'ordre d'une ou plusieurs centaines de gigahertz, pour des applications d'imagerie médicale et de contrôle industriel, d'observation de la terre et de l'espace profond, ainsi que pour les radars et les systèmes de télécommunication large bande.

Les commutateurs RF sont classiquement réalisés, selon le niveau de performance souhaité, à base de transistors à effet de champ, de diodes PIN, de relais électromécaniques ou de composants MEMS (de l'anglais « Microelectromechanical system » - microsystème électromécanique). Ces commutateurs ne donnent toutefois pas entière satisfaction, notamment pour des applications haute fréquence, par exemple aux alentours de 100 GHz. Les performances d'un commutateur RF dépendent d'un paramètre appelé « figure de mérite » (« Figure of Merit » - FoM, en anglais), égal au produit de la résistance à l'état passant R_{ON} par la capacité à l'état bloqué C_{OFF} du commutateur RF. La résistance R_{ON} et la capacité C_{OFF} traduisent respectivement des pertes d'insertion du commutateur à l'état passant et une isolation du commutateur à l'état bloqué, deux grandeurs à minimiser pour les applications radiofréquence.

En vue de dépasser les limites des commutateurs RF précités, des commutateurs à base d'un matériau à changement de phase, capable d'alterner entre une phase cristalline, électriquement conductrice, et une phase amorphe, électriquement isolante, ont été proposés. Les commutateurs à base d'un matériau à changement de phase présentent, par rapport aux commutateurs RF classiques à base de transistors et de diodes PIN, une figure de mérite environ dix fois inférieure. La figure de mérite est par exemple de l'ordre de 100 fs pour les commutateurs RF à base de transistors et de diodes PIN, contre environ 10 fs pour les commutateurs RF à base de matériau à changement de phase. Ces derniers présentent en outre l'avantage de comporter des états passant et bloqué non volatiles, le commutateur ne requérant aucune consommation énergétique pour être maintenu dans l'un ou l'autre état. Les commutateurs RF à base de MEMS peuvent atteindre des figures de mérite relativement faibles, mais présentent divers inconvénients, notamment des problèmes de fiabilité et d'encombrement important, et présentent des états volatiles.

Parmi les commutateurs à base de matériau à changement de phase, des commutateurs à chauffage direct, commandés par circulation d'un courant à travers le matériau à changement de phase, ou à chauffage indirect, par exemple par circulation d'une impulsion de courant à travers un élément chauffant électriquement isolé du matériau à changement de phase, ont été proposés. Toutefois, ces commutateurs présentent divers inconvénients. Dans les commutateurs à chauffage direct, le signal de commande perturbe le signal radiofréquence transmis entre les électrodes de conduction du commutateur. Dans les commutateurs à chauffage indirect, l'élément chauffant est à l'origine d'une capacité parasite et de résistances parasites. Par ailleurs, les commutateurs à chauffage indirect comportent des pistes conductrices métalliques utilisées pour transmettre le signal de commande depuis une source de courant jusqu'à l'élément chauffant. Dans le cas où le commutateur RF fait partie d'une antenne reconfigurable, la présence de ces pistes perturbe fortement le champ rayonné par l'antenne.

Afin de pallier ces inconvénients, des commutateurs RF à base de matériau à changement de phase et à actionnement optique ont été proposés. L'actionnement optique est, dans ces commutateurs, réalisé par irradiation directe du matériau à changement de phase au moyen d'un laser. Cela nécessite toutefois d'aligner précisément le faisceau laser avec le matériau à changement de phase, complexifiant ainsi fortement l'intégration de tels commutateurs en particulier dans des applications d'antennes reconfigurables pouvant comporter des centaines de commutateurs.

### Résumé de l'invention

Il existe un besoin de pallier tout ou partie des inconvénients des commutateurs existants. En particulier, il serait souhaitable d'optimiser la réalisation de commutateurs à base de matériau à changement de phase à actionnement optique.

Pour cela, un mode de réalisation prévoit un commutateur à base d'un matériau à changement de phase à actionnement optique formé sur un substrat de support et comprenant :
- une région en ledit matériau à changement de phase reliant des première et deuxième électrodes de conduction du commutateur ; et
- un guide d'ondes interposé entre le substrat de support et la région en ledit matériau à changement de phase et comportant une région centrale en un premier matériau présentant un premier indice optique entourée d'une région périphérique en un deuxième matériau présentant un deuxième indice optique, inférieur au premier indice optique.

Selon un mode de réalisation, la région centrale du guide d'ondes est séparée de la région en ledit matériau à changement de phase par une distance inférieure ou égale à 100 nm, de préférence inférieure ou égale à 50 nm, plus préférentiellement égale à environ 20 nm.

Selon un mode de réalisation, le guide d'ondes comprend en outre un élément de couplage d'entrée présentant une structure de Bragg comprenant des portions d'anneaux concentriques espacées de façon régulière.

Selon un mode de réalisation, le commutateur comprend en outre une source laser destinée à illuminer l'élément de couplage par un rayonnement laser présentant une longueur d'onde centrale égale à environ 915 nm.

Selon un mode de réalisation, l'élément de couplage d'entrée est séparé du substrat de support par une distance égale à environ 1 500 nm, à plus ou moins 100 nm près.

Selon un mode de réalisation, la région centrale du guide d'ondes est séparée du substrat de support par une distance égale à environ 1 500 nm, à plus ou moins 100 nm près.

Selon un mode de réalisation, le commutateur comprend en outre des premier et deuxième vias conducteurs s'étendant entre la région en ledit matériau à changement de phase et les première et deuxième électrodes de conduction, respectivement.

Selon un mode de réalisation, la région centrale du guide d'ondes est séparée des premier et deuxième vias conducteurs par une distance supérieure ou égale à 0,3 µm.

Selon un mode de réalisation, la région en ledit matériau à changement de phase est revêtue d'une couche de passivation.

Selon un mode de réalisation, les régions centrale et périphérique du guide d'ondes sont respectivement en nitrure de silicium et en dioxyde de silicium.

Selon un mode de réalisation, la région centrale du guide d'ondes présente une hauteur égale à environ 300 nm et une largeur égale à environ 600 nm.

Un autre mode de réalisation prévoit un procédé de fabrication d'un commutateur à base d'un matériau à changement de phase à actionnement optique comprenant les étapes successives suivantes :
a) former, sur un substrat de support, des première et deuxième électrodes de conduction du commutateur ;
b) former, sur le substrat de support, un guide d'ondes comportant une région centrale en un premier matériau présentant un premier indice optique entourée d'une région périphérique en un deuxième matériau présentant un deuxième indice optique, inférieur au premier indice optique ; et
c) former, sur le substrat de support, une région en ledit matériau à changement de phase reliant les première et deuxième électrodes de conduction du commutateur, le guide d'ondes étant interposé entre le substrat de support et la région en ledit matériau à changement de phase.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue de dessus, schématique et partielle, d'un exemple de commutateur à base de matériau à changement de phase selon un mode de réalisation ;
la figure 1B et la figure 1C sont des vues en coupe respectivement selon les plans BB et CC de la figure 1A, schématiques et partielles, du commutateur à base de matériau à changement de phase de la figure 1A ; et
la figure 2A, la figure 2B, la figure 2C, la figure 2D et la figure 2E sont des vues en coupe selon le plan CC de la figure 1A, schématiques et partielles, illustrant des étapes successives d'un exemple de procédé de fabrication du commutateur à base de matériau à changement de phase des figures 1A, 1B et 1C selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications dans lesquelles peuvent être prévus des commutateurs à base de matériau à changement de phase ne sont pas détaillées, les modes de réalisation et variantes décrits étant compatibles avec les applications usuelles mettant en oeuvre des commutateurs.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

Dans la description qui suit, les qualificatifs « isolant » et « conducteur » signifient respectivement, sauf précision contraire, électriquement isolant et électriquement conducteur.

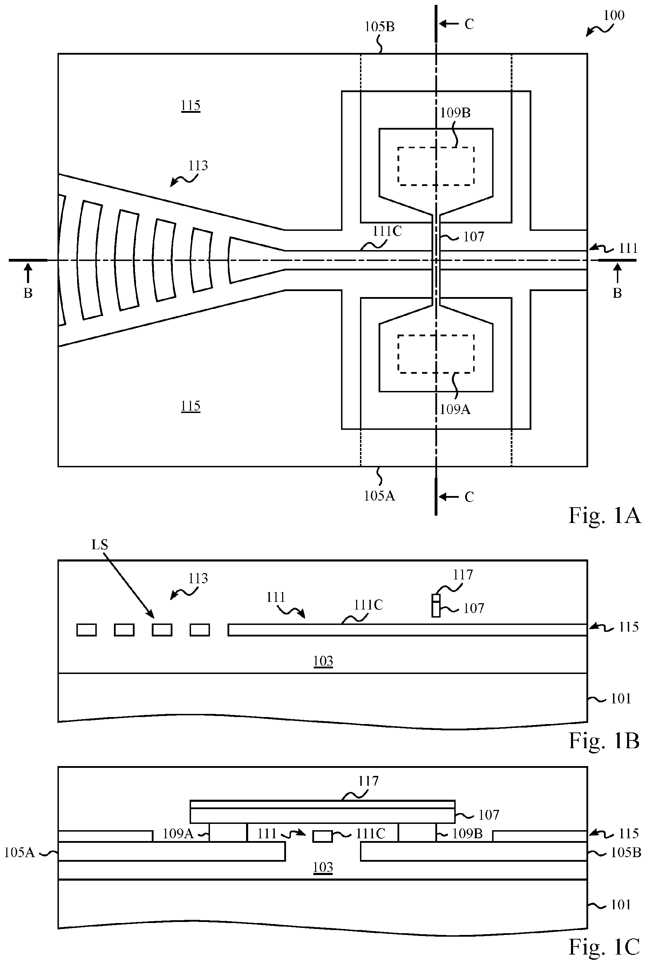

La figure 1A est une vue de dessus, schématique et partielle, d'un exemple de commutateur 100 à base de matériau à changement de phase selon un mode de réalisation. La figure 1B et la figure 1C sont des vues en coupe respectivement selon les plans BB et CC de la figure 1A, schématiques et partielles, du commutateur 100 à base de matériau à changement de phase de la figure 1A. Dans l'exemple illustré, le plan BB est orthogonal à la direction de conduction du commutateur 100 et le plan CC est parallèle à la direction de conduction du commutateur 100.

Dans l'exemple représenté, le commutateur 100 est formé sur un substrat de support 101. Le substrat de support 101 est par exemple une plaquette ou un morceau de plaquette en un matériau semiconducteur, par exemple le silicium. À titre de variante, le substrat de support 101 peut être en un matériau isolant, par exemple en verre, en quartz, etc. Dans l'orientation des figures 1A, 1B et 1C, les plans BB et CC sont orthogonaux à la face supérieure du substrat de support 101.

Dans l'exemple illustré, le substrat de support 101 est revêtu d'une couche isolante 103. Dans l'orientation des figures 1A, 1B et 1C, la couche isolante 103 est située sur et en contact avec la face supérieure du substrat de support 101. À titre d'exemple, la couche 103 est une couche d'oxyde, par exemple le dioxyde de silicium (SiO₂). La couche isolante 103 n'a pas été représentée en figure 1A afin de ne pas surcharger le dessin.

Dans l'exemple représenté, le commutateur 100 comprend en outre des électrodes de conduction 105A et 105B séparées du substrat de support 101 par des parties de la couche isolante 103. Des parties de la couche isolante 103 sont ainsi interposées verticalement entre la face supérieure du substrat de support 101 et les électrodes de conduction 105A et 105B. Dans l'exemple illustré, les électrodes de conduction 105A et 105B sont séparées l'une de l'autre par une partie de la couche isolante 103 s'étendant latéralement entre elles. Les électrodes de conduction 105A et 105B sont par exemple destinées à être connectées à un circuit de communication radiofréquence, non détaillé sur les figures. Les électrodes de conduction 105A et 105B sont en un matériau conducteur. À titre d'exemple, les électrodes de conduction 105A et 105B sont en un métal, par exemple le cuivre ou l'aluminium, ou en un alliage métallique. Par ailleurs, les électrodes de conduction 105A et 105B peuvent présenter une structure monocouche ou multicouche. Dans le cas d'une structure multicouche, les électrodes de conduction 105A et 105B sont par exemple constituées d'un empilement comprenant, de bas en haut dans l'orientation des figures 1B et 1C :
- une couche en titane présentant par exemple une épaisseur égale à environ 10 nm ;
- une couche en un alliage de cuivre et d'aluminium présentant par exemple une épaisseur égale à environ 440 nm ;
- une couche en titane présentant par exemple une épaisseur égale à environ 10 nm ; et
- une couche en nitrure de titane présentant par exemple une épaisseur égale à environ 100 nm.

Dans l'exemple illustré, le commutateur 100 comprend en outre une région 107 en un matériau à changement de phase reliant les électrodes de conduction 105A et 105B. Dans cet exemple, la région 107 en matériau à changement de phase s'étend latéralement à l'aplomb d'une partie de chaque électrode de conduction 105A, 105B. Une première extrémité de la région 107 en matériau à changement de phase est située à l'aplomb de l'électrode de conduction 105A et une deuxième extrémité de la région 107, opposée à la première extrémité, est située à l'aplomb de l'électrode de conduction 105B. À titre d'exemple, la région 107 en matériau à changement de phase présente une épaisseur de l'ordre de 100 nm.

Dans l'exemple représenté, des vias conducteurs 109A et 109B s'étendent verticalement, à travers une partie de la couche isolante 103, depuis la face inférieure de la région 107 en matériau à changement de phase jusqu'aux faces supérieures des électrodes de conduction 105A et 105B, respectivement. Les vias conducteurs 109A et 109B sont situés respectivement au voisinage des première et deuxième extrémités de la région 107 en matériau à changement de phase et permettent de connecter électriquement la région 107 avec les électrodes de conduction 105A et 105B, respectivement. À titre d'exemple, les vias conducteurs 109A et 109B sont en un métal, par exemple le cuivre, l'aluminium ou le tungstène, ou en un alliage métallique.

Dans l'exemple illustré, les faces latérales des vias conducteurs 109A et 109B sont bordées, ou revêtues, par la couche isolante 103. Par ailleurs, les faces latérales et les parties de la face inférieure de la région 107 en matériau à changement de phase non situées en contact avec les faces supérieures de vias conducteurs 109A et 109B sont bordées, ou revêtues, par la couche isolante 103.

La région 107 en matériau à changement de phase est par exemple en un matériau dit « chalcogénure », c'est-à-dire un matériau ou un alliage comprenant au moins un élément chalcogène, par exemple un matériau de la famille du tellurure de germanium (GeTe), du tellurure d'antimoine (SbTe) ou du germanium-antimoine-tellure (GeSbTe, communément désigné par l'acronyme « GST »). À titre de variante, la région 107 est en dioxyde de vanadium (VO₂).

De manière générale, les matériaux à changement de phase sont des matériaux capables d'alterner, sous l'effet d'une variation de température, entre une phase cristalline et une phase amorphe, la phase amorphe présentant une résistance électrique supérieure à celle de la phase cristalline. Dans le cas du commutateur 100, on tire profit de ce phénomène pour obtenir un état bloqué, empêchant la circulation d'un courant entre les électrodes de conduction 105A et 105B, lorsque le matériau de la région 107 est dans la phase amorphe, et un état passant, autorisant la circulation du courant entre les électrodes de conduction 105A et 105B, lorsque le matériau de la région 107 est dans la phase cristalline.

Dans l'exemple représenté, le commutateur 100 comprend en outre un guide d'ondes 111 interposé entre le substrat de support 101 et la région 107 en matériau à changement de phase. Dans cet exemple, le guide d'ondes 111 s'étend latéralement le long d'une direction principale sensiblement orthogonale à la direction de conduction du commutateur 100. Dans l'exemple illustré, le guide d'ondes 111 comprend une région centrale 111C, ou âme, entourée d'une région périphérique isolante constituée par une partie de la couche isolante 103. La région centrale 111C et la région périphérique du guide d'ondes 111 sont en des matériaux choisis de sorte à obtenir un contraste d'indices optiques permettant de confiner et guider un mode optique d'intérêt, émis par une source laser LS, à l'intérieur de la région centrale 111C. À titre d'exemple, la source laser LS comprend une diode laser ou un laser pulsé.

Le matériau de la région centrale 111C du guide d'ondes 111 présente un indice optique supérieur à celui de la région périphérique. À titre d'exemple, la région centrale 111C du guide d'ondes 111 est en nitrure de silicium (SiN) et la région périphérique est en dioxyde de silicium. L'utilisation du nitrure de silicium pour la réalisation de la région centrale 111C présente l'avantage d'être compatible avec des procédés de fabrication CMOS (de l'anglais « Complementary Métal Oxide Semiconductor » - métal oxyde semiconducteur complémentaire). Par ailleurs, le nitrure de silicium permet d'obtenir une grande uniformité d'épaisseur, un bon confinement de l'onde optique lors de la propagation dans le guide d'ondes 111 et de faibles pertes de propagation. À l'exception de la partie située à l'aplomb de la région 107 en matériau à changement de phase, la région centrale 111C du guide d'ondes 111 est par exemple entourée par une épaisseur de matériau de la couche isolante 103 supérieure à 1,5 µm afin de limiter les pertes de propagation dans le guide d'ondes 111.

Le plan CC de la figure 1C est sensiblement orthogonal à une direction de propagation du rayonnement laser dans le guide d'ondes 111. Dans l'exemple représenté, la région périphérique du guide d'ondes 111 (la couche isolante 103, dans cet exemple) revêt, ou borde, les faces de la région centrale 111C parallèles à la direction de propagation du rayonnement laser (les faces latérales, inférieure et supérieure de la région centrale 111C parallèles à un axe orthogonal au plan CC). Dans cet exemple, une partie de la couche isolante 103 s'étend verticalement depuis une face de la région centrale 111C située en regard de la région 107 en matériau à changement de phase (la face supérieure de la région centrale 111C, dans l'orientation de la figure 1C) jusqu'à une face de la région 107 en matériau à changement de phase située en vis-à-vis (la face inférieure de la région 107, dans l'orientation de la figure 1C).

Dans l'exemple représenté, la région centrale 111C présente, en vue en coupe selon le plan CC orthogonal à la direction de propagation du rayonnement laser dans le guide d'ondes 111, une section de forme sensiblement rectangulaire. À titre d'exemple, la section de la région centrale 111C présente une largeur égale à environ 600 nm et une hauteur, ou épaisseur, égale à environ 300 nm. Par ailleurs, la région centrale 111C est séparée de la région 107 en matériau à changement de phase par une distance inférieure ou égale à 100 nm, par exemple inférieure ou égale à 50 nm, par exemple égale à environ 20 nm. Dans cet exemple, la distance séparant la région centrale 111C de la région 107 en matériau à changement de phase correspond à une épaisseur d'une partie de la couche isolante 103 interposée entre la région centrale 111C et la région 107 en matériau à changement de phase. À titre de variante, la région 107 en matériau à changement de phase peut être située sur et en contact avec la région centrale 111C du guide d'ondes 111.

Le couplage de la puissance optique du rayonnement transmis à l'intérieur de la région centrale 111C du guide d'ondes 111 avec le matériau à changement de phase de la région 107 s'effectue par champ évanescent. Les inventeurs se sont aperçus que plus la région centrale 111C est proche de la région 107, plus le taux de couplage optique est élevé et plus la réflexion, due au changement d'indice, est forte. En revanche, plus la région centrale 111C est éloignée de la région 107, plus la réflexion est faible et plus le taux de couplage est faible. La distance séparant la région 107 en matériau à changement de phase de la région centrale 111C du guide d'ondes 111 est par exemple choisie de sorte à obtenir un compromis entre l'absorption de l'onde optique par le matériau à changement de phase de la région 107 et la réflexion de l'onde optique sur la face d'entrée de la région 107 en matériau à changement de phase (la face inférieure de la région 107, dans l'orientation des figures 1B et 1C).

À titre d'exemple, la région centrale 111C du guide d'ondes 111 est séparée latéralement des vias conducteurs 109A et 109B par une distance supérieure ou égale à 0,3 µm, dans un cas où les vias conducteurs 109A et 109B présentent, le long de l'axe de propagation du rayonnement à l'intérieur de la région centrale 111C du guide d'ondes 111, une dimension latérale inférieure à 10 µm, et une distance supérieure ou égale à 0,5 µm, par exemple supérieure ou égale à 1 µm, dans un cas où les vias conducteurs 109A et 109B présentent, le long de l'axe de propagation du rayonnement à l'intérieur de la région centrale 111C du guide d'ondes 111, une dimension latérale supérieure ou égale à 10 µm. Cela permet d'éviter ou de limiter l'absorption, par le matériau des vias conducteurs 109A et 109B, du rayonnement transmis par le guide d'ondes 111.

Le guide d'ondes 111 est par exemple de type monomode, c'est-à-dire qu'il est adapté à confiner et guider un seul mode optique pour chaque type de polarisation. Le guide d'ondes 111 est par exemple plus précisément adapté à confiner et guider un seul mode optique choisi parmi un mode transverse électrique d'ordre zéro (TE0) et un mode transverse magnétique d'ordre zéro (TM0). Du fait que les modes TE0 et TM0 sont orthogonaux, ils ne peuvent pas se coupler mutuellement dans le guide d'ondes 111. Le choix du mode confiné et guidé par le guide d'ondes 111, entre le mode TEC et le mode TM0, est déterminé par la polarisation de la source laser LS. Ainsi, dans un cas où la source laser LS émet un rayonnement présentant une polarisation transverse électrique TE, le guide d'ondes 111 est adapté à confiner et guider le mode transverse électrique d'ordre zéro TE0 uniquement.

À titre d'exemple, le rayonnement émis par la source laser LS présente une longueur d'onde centrale de l'ordre de 915 nm. Cela permet d'obtenir un compromis entre l'absorption du rayonnement par le matériau à changement de phase de la région 107, qui est d'autant plus importante que la longueur d'onde d'émission de la source laser LS est petite, et l'atténuation du rayonnement transmis par le guide d'ondes 111, qui est d'autant plus faible que la longueur d'onde d'émission de la source laser LS est grande. À titre d'exemple, l'absorption du rayonnement par le matériau à changement de phase est deux fois plus importante lorsque la longueur d'onde du rayonnement est égale à environ 915 nm que lorsqu'elle est égale à environ 1 550 nm. Par ailleurs, dans le cas où la région 111C est en nitrure de silicium, l'atténuation du rayonnement transmis par le guide d'ondes 111 devient trop importante à des longueurs d'ondes inférieures à 500 nm pour permettre d'obtenir un changement de phase du matériau de la région 107.

Du côté de son extrémité destinée à être illuminée par la source laser LS, le guide d'ondes 111 comprend par exemple un élément de couplage d'entrée 113, aussi appelé surface d'entrée du guide d'ondes 111. Dans l'exemple représenté, l'élément de couplage d'entrée 113 est un réseau de diffraction présentant une structure de Bragg permettant de capter le rayonnement émis par la source laser LS et de propager ce rayonnement le long du guide d'ondes 111 jusqu'à l'aplomb de la région 107 en matériau à changement de phase. Dans l'exemple illustré, l'élément de couplage d'entrée 113 comprend des portions d'anneaux concentriques espacées de façon régulière, par exemple espacées d'une distance égale à environ 340 nm, et présentant par exemple chacune, en vue de dessus, des largeurs identiques, par exemple de l'ordre de 340 nm. Cela permet avantageusement de pouvoir réaliser l'élément de couplage d'entrée 113 au moyen d'équipements de photolithographie présentant une résolution de l'ordre de 300 nm, la largeur et l'espacement des parties d'anneaux de l'élément de couplage d'entrée 113 étant d'autant plus faibles que la longueur d'onde centrale du rayonnement laser émis par la source LS est petite.

Les portions d'anneaux de l'élément de couplage d'entrée 113 sont séparées latéralement les unes des autres par des parties de la couche isolante 103. À titre d'exemple, les portions d'anneaux concentriques de l'élément de couplage d'entrée 113 sont en le même matériau que la région centrale 111C du guide d'ondes 111. La région centrale 111C du guide d'ondes 111 et les anneaux de l'élément de couplage d'entrée 113 sont par exemple formés dans une même couche isolante 115. La couche isolante 115 s'étend par exemple au-dessus de la majorité de la face supérieure du substrat de support 101. Dans l'exemple représenté, des parties de la couche isolante 115 sont situées sur et en contact avec des parties des faces supérieures des électrodes de conduction 105A et 105B.

L'élément de couplage d'entrée 113 est par exemple séparé du substrat de support 101 par une distance égale à environ 1 500 nm, à plus ou moins 100 nm près. Cela permet avantageusement de tirer profit d'une réflexion constructive de l'onde optique transmise par le guide d'ondes 111 sur la face supérieure du substrat de support 101, notamment dans le cas où le substrat de support 101 est en silicium, et d'optimiser un couplage entre la source laser LS et le guide d'ondes 111 au moyen de l'élément de couplage d'entrée 113.

La région centrale 111C du guide d'ondes 111 est par exemple séparée du substrat de support 101 par une distance supérieure à 1 µm. Cela permet avantageusement d'éviter ou de limiter des phénomènes d'absorption optique, par le substrat de support 101, du rayonnement transmis par le guide d'ondes 111. Dans l'exemple représenté, la région centrale 111C du guide d'ondes 111 est séparée du substrat de support 101 par la même distance que l'élément de couplage d'entrée 113. Dans ce cas, la région centrale 111C est séparée du substrat de support 101 par une distance égale à environ 1 500 nm, à plus ou moins 100 nm près. Les électrodes de conduction 105A et 105B, et les parties de la couche isolante 103 interposées entre le substrat de support 101 et les électrodes de conduction 105A et 105B présentent par exemple une épaisseur cumulée égale à environ 1 500 nm, à plus ou moins 100 nm près. À titre d'exemple, les électrodes de conduction 105A et 105B présentent chacune une épaisseur égale à environ 560 nm, et les parties de la couche isolante 103 interposées entre le substrat de support 101 et les électrodes de conduction 105A et 105B présentent une épaisseur égale à environ 940 nm.

À titre de variante, une couche isolante, par exemple une couche en dioxyde de silicium, présentant par exemple une épaisseur égale à environ 20 nm, peut être interposée entre la couche isolante 115 et les électrodes de conduction 105A et 105B. Dans ce cas, l'épaisseur des électrodes de conduction 105A et 105B et/ou l'épaisseur des parties de la couche isolante 103 interposées entre le substrat de support 101 et les électrodes de conduction 105A et 105B sont adaptées pour obtenir, entre la face inférieure de la région 107 en matériau à changement de phase et la face supérieure du substrat de support 101, une distance égale à environ 1 500 nm, à plus ou moins 100 nm près. À titre d'exemple, dans le cas où une couche isolante d'environ 20 nm d'épaisseur est prévue entre la couche isolante 115 et les électrodes de conduction 105A et 105B, les électrodes de conduction 105A et 105B présentent chacune une épaisseur égale à environ 560 nm, et les parties de la couche isolante 103 interposées entre le substrat de support 101 et les électrodes de conduction 105A et 105B présentent une épaisseur égale à environ 920 nm.

Dans l'exemple représenté, la face de la région 107 en matériau à changement de phase opposée au substrat de support 101 (la face supérieure de la région 107, dans l'orientation des figures 1B et 1C) est revêtue d'une couche de passivation 117. Dans cet exemple, la couche de passivation 117 est située sur et en contact avec la face supérieure de la région 107 en matériau à changement de phase. La couche de passivation 117 permet de protéger le matériau à changement de phase de la région 107 contre l'oxydation. Dans l'exemple représenté, les faces latérales et supérieure de la couche de passivation 117 sont revêtues par la couche isolante 103. Dans l'exemple illustré, une partie de la couche isolante 103 s'étend sur la face supérieure de la couche de passivation 117. La couche de passivation 117 présente par exemple une épaisseur égale à environ 20 nm. À titre d'exemple, la couche de passivation 117 est en nitrure de silicium ou en nitrure de germanium. La couche de passivation 117 n'a pas été représentée en figure 1A afin de ne pas surcharger le dessin. À titre de variante, la couche de passivation 117 peut être omise.

Bien que cela n'ait pas été illustré en figures 1A, 1B et 1C, le commutateur 100 peut en outre comprendre des éléments de reprise de contact et/ou des pistes conductrices, par exemple métalliques, situés sur et en contact avec la face supérieure de la couche isolante 103. Les éléments de reprise de contact et/ou les pistes conductrices sont par exemple connectés aux électrodes de conduction 105A et 105B du commutateur 100, et assurent par exemple une fonction de routage de signaux radiofréquence. Les éléments de reprise de contact et/ou les pistes conductrices sont par exemple séparés de la région centrale 111C du guide d'ondes 111 par une distance supérieure à 1 µm, par exemple supérieure à 1,5 µm. Cela permet de limiter ou d'éviter l'absorption, par le matériau des éléments de reprise de contact et/ou des pistes conductrices, du rayonnement transmis par le guide d'ondes 111.

Pour faire basculer le commutateur 100 de l'état bloqué à l'état passant, on chauffe par exemple la région 107, à l'aide de la source laser LS, par l'intermédiaire du guide d'ondes 111, à une température T1 et pendant une durée d1. La température T1 et la durée d1 sont choisies de sorte à provoquer un changement de phase du matériau de la région 107 depuis la phase amorphe vers la phase cristalline. À titre d'exemple, la température T1 est supérieure à une température de cristallisation et inférieure à une température de fusion du matériau à changement de phase et la durée d1 est comprise entre 100 ns et 1 ps.

À l'inverse, pour faire basculer le commutateur 100 de l'état passant à l'état bloqué, on chauffe par exemple la région 107, à l'aide de la source laser LS, par l'intermédiaire du guide d'ondes 111, à une température T2, supérieure à la température T1, et pendant une durée d2, inférieure à la durée d1. La température T2 et la durée d2 sont choisies de sorte à provoquer un changement de phase du matériau de la région 107 depuis la phase cristalline vers la phase amorphe. À titre d'exemple, la température T2 est supérieure à la température de fusion du matériau à changement de phase et la durée d2 est comprise entre 10 ns et 100 ns.

Un avantage du commutateur 100 tient au fait que le guide d'ondes 111 est placé sous la région 107 en matériau à changement de phase, c'est-à-dire entre le substrat de support 101 et la région 107 en matériau à changement de phase. Cela permet de prévoir la couche de passivation 117 sur la région 107 en matériau à changement de phase afin de protéger ce matériau contre l'oxydation lors des étapes de fabrication et d'utilisation du commutateur 100. Si le guide d'ondes 111 avait été placé au-dessus de la région 107 en matériau à changement de phase, par exemple si la région centrale 111C du guide d'ondes avait été située sur et en contact avec la couche de passivation 117, cela aurait dégradé le confinement de l'onde optique à l'intérieur du guide d'ondes et cela aurait diminué le couplage avec le matériau à changement de phase de la région 107. Par ailleurs, le fait de prévoir que la région centrale 111C du guide d'ondes 111 soit située au-dessus de la région 107 en matériau à changement de phase nécessiterait de graver le matériau de la région centrale 111C en s'arrêtant sur le matériau à changement de phase de la région 107, ce qui risquerait d'endommager ce dernier. Cela complexifierait grandement la réalisation du commutateur 100.

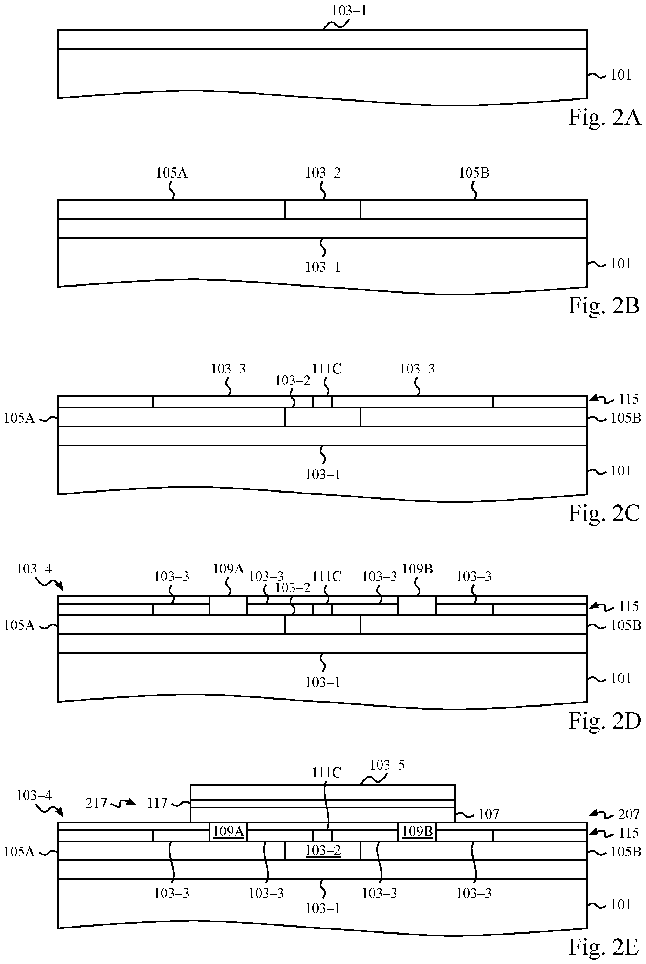

La figure 2A, la figure 2B, la figure 2C, la figure 2D et la figure 2E sont des vues en coupe selon le plan CC de la figure 1A, schématiques et partielles, illustrant des étapes successives d'un exemple de procédé de fabrication du commutateur 100 à base de matériau à changement de phase des figures 1A, 1B et 1C selon un mode de réalisation.

La figure 2A illustre plus précisément une structure obtenue à l'issue d'une étape de formation d'une partie 103-1 de la couche isolante 103 du côté de la face supérieure du substrat de support 101. La partie 103-1 de la couche isolante 103 est par exemple une couche d'oxyde thermique située sur et en contact avec la face supérieure du substrat de support 101.

La figure 2B illustre plus précisément une structure obtenue à l'issue d'étapes de formation des électrodes de conduction 105A et 105B et d'une autre partie 103-2 de la couche isolante 103 du côté de la face supérieure du substrat de support 101.

À titre d'exemple, une ou plusieurs couches conductrices, par exemple en un métal ou en un alliage métallique, sont d'abord déposées successivement sur toute la face supérieure de la partie 103-1 de la couche isolante 103. Lors de cette étape, la ou les couches conductrices sont par exemple formées par PVD (de l'anglais « Physical Vapor Déposition » - dépôt physique en phase vapeur) . Les électrodes de conduction 105A et 105B sont par exemple ensuite formées par photolithographie puis gravure de la ou des couches conductrices.

La partie 103-2 de la couche isolante 103 est ensuite déposée du côté de la face supérieure du substrat de support 101. La partie 103-2 de la couche isolante 103 revêt alors les parties de la face supérieure de la partie 103-1 non revêtues par les électrodes de conduction 105A et 105B, ainsi que les faces latérales et supérieures des électrodes de conduction 105A et 105B. La partie 103-2 de la couche isolante 103 est par exemple formée par PECVD (de l'anglais « Plasma-Enhanced Chemical Vapor Déposition » - dépôt chimique en phase vapeur assisté par plasma), par exemple par HDPCVD (de l'anglais « High-Density Plasma Chemical Vapor Déposition » - dépôt physique en phase vapeur utilisant un plasma de haute densité). À titre d'exemple, la partie 103-2 de la couche isolante 103 présente, après dépôt, une épaisseur de l'ordre de 700 nm. Cette épaisseur est par exemple ensuite réduite par une opération de polissage mécano-chimique (« Chemical and Mechanical Polishing » - CMP, en anglais) avec arrêt sur les électrodes de conduction 105A et 105B, de sorte que la partie 103-2 de la couche isolante 103 affleure la face supérieure des électrodes de conduction 105A et 105B.

La figure 2C illustre plus précisément une structure obtenue à l'issue d'étapes de :
a) dépôt de la couche isolante 115 du côté de la face supérieure du substrat de support 101 ;
b) structuration de la couche isolante 115 ; et
c) dépôt d'une autre partie 103-3 de la couche isolante 103 du côté de la face supérieure du substrat de support 101.

À titre d'exemple, le dépôt de la couche isolante 115 est effectué par PECVD. La couche isolante 115 présente par exemple une épaisseur égale à environ 300 nm. La région centrale 111C et l'élément de couplage d'entrée 113 (non visible en figure 2C) du guide d'ondes 111 sont formés à l'issue de l'étape de structuration, par exemple par photolithographie puis gravure, de la couche isolante 115.

À titre d'exemple, le dépôt de la partie 103-3 de la couche isolante 103 est effectué par HDPCVD. La partie 103-3 de la couche isolante 103 présente par exemple, après dépôt, une épaisseur de l'ordre de 500 nm. La partie 103-3 de la couche isolante 103 est par exemple ensuite planarisée, par exemple par une opération de polissage mécano-chimique avec arrêt sur les parties de la couche isolante 115 qui subsistent après structuration de sorte que la partie 103-3 de la couche isolante 103 affleure la face supérieure de la couche isolante 115.

La couche isolante 115 présente par exemple, en vue de dessus, une surface égale à au moins 35 %, par exemple égale à au moins 75 % et pouvant atteindre 90 %, de la surface du substrat de support 101. Cela permet avantageusement de faciliter l'arrêt de l'étape de polissage mécano chimique de la partie 103-3 de la couche isolante 103.

La figure 2D illustre plus précisément une structure obtenue à l'issue d'étapes de dépôt d'une autre partie 103-4 de la couche isolante 103 du côté de la face supérieure du substrat de support 101 et de formation des vias conducteurs 109A et 109B.

À titre d'exemple, le dépôt de la partie 103-4 de la couche isolante 103 est effectué par PECVD. La partie 103-4 de la couche isolante 103 présente par exemple, après dépôt, une épaisseur inférieure ou égale à 100 nm, par exemple inférieure ou égale à 50 nm, par exemple égale à environ 20 nm.

À titre de variante, le dépôt de la partie 103-4 de la couche isolante 103 peut être omis.

Les vias conducteurs 109A et 109B sont par exemple formés par photolithographie puis gravure, par exemple gravure ionique réactive (« Reactive Ion Etching » - RIE, en anglais), puis dépôt d'une ou plusieurs couches conductrices, par exemple en un métal ou en un alliage métallique, du côté de la face supérieure du substrat de support 101.

Dans l'exemple représenté, les vias conducteurs 109A et 109B s'étendent verticalement depuis la face supérieure de la partie 103-4 de la couche isolante 103 jusqu'aux faces supérieures des électrodes de conduction 105A et 105B, respectivement. À titre d'exemple, chaque via conducteur 109A, 109B est constitué d'un empilement comprenant une couche de nitrure de titane présentant par exemple une épaisseur égale à environ 30 nm et formée par PVD revêtue d'une couche de tungstène formée par CVD (de l'anglais « Chemical Vapor Déposition » - dépôt chimique en phase vapeur). L'empilement est par exemple ensuite planarisé par polissage mécano-chimique avec arrêt sur la partie 103-4 de la couche isolante 103 ou avec arrêt sur la couche isolante 115, dans la variante où la partie 103-4 de la couche isolante 103 est omise.

La figure 2E illustre plus précisément une structure obtenue à l'issue d'étapes successives de :
a) dépôt d'une couche 207 en matériau à changement de phase du côté de la face supérieure du substrat de support 101 ;
b) dépôt d'une couche isolante 217 du côté de la face supérieure du substrat de support 101 ;
c) dépôt d'une autre partie 103-5 de la couche isolante 103 du côté de la face supérieure du substrat de support 101 ; et
d) structuration des couches 207 et 217 et de la partie 103-5 de la couche isolante 103.

À titre d'exemple, la couche 207 en matériau à changement de phase est déposée par PVD.

La partie 103-5 de la couche isolante 103 est par exemple structurée par photolithographie puis gravure, par exemple gravure RIE, de sorte à ne conserver qu'une région de la partie 103-5 située à l'aplomb de la future région 107 en matériau à changement de phase. La partie 103-5 de la couche isolante 103 est par exemple ensuite utilisée comme masque dur pour structurer la couche de passivation 217 et la couche en matériau à changement de phase 207. Les couches 217 et 207 sont par exemple structurées simultanément, au cours d'une même étape de photolithographie puis gravure, par exemple gravure RIE. La région 107 en matériau à changement de phase et la couche de passivation 117 précédemment décrites en relation avec les figures 1A, 1B et 1C sont alors obtenues.

Partant de la structure illustrée en figure 2E, des étapes ultérieures de dépôt d'une autre partie de la couche isolante 103, présentant par exemple une épaisseur de l'ordre de 2 µm, puis de polissage, par exemple par CMP, de cette partie de la couche isolante 103, par exemple de sorte à obtenir une épaisseur de l'ordre de 1,5 µm au-dessus de la région centrale 111C du guide d'ondes 111, peuvent être mises en oeuvre. La structure précédemment décrite en relation avec les figures 1A, 1B et 1C est par exemple ainsi obtenue. Pour simplifier, les figures 1A, 1B et 1C illustrent un exemple dans lequel les parties 103-1, 103-2, 103-3, 103-4 et 103-5 de la couche isolante 103 sont en un même matériau. Cet exemple n'est toutefois pas limitatif, les différentes parties de la couche isolante 103 précédemment décrites en relation avec les figures 2A à 2E pouvant, à titre de variante, être en des matériaux différents.

Par ailleurs, bien que cela n'ait pas été détaillé sur les figures, des étapes ultérieures de formation de vias conducteurs s'étendant verticalement depuis la face supérieure de la couche isolante 103 jusqu'à la face supérieure des électrodes de conduction 105A et 105B, à travers la couche isolante 115, suivies d'étapes de formation d'éléments de reprise de contact et/ou de pistes conductrices situés sur et en contact avec les faces supérieures de ces vias peuvent ensuite être mises en oeuvre. À titre d'exemple, les vias conducteurs sont formés par réalisation d'ouvertures par photolithographie puis gravure, par exemple gravure RIE, dans les couches isolantes 103 et 115, ces ouvertures étant par exemple ensuite remplies d'un métal ou d'un alliage métallique.

À titre d'exemple, chaque élément de reprise de contact est constitué d'un empilement comprenant, de bas en haut dans l'orientation des figures 1B et 1C :
- une couche en titane présentant par exemple une épaisseur égale à environ 10 nm ;
- une couche en un alliage de cuivre et d'aluminium présentant par exemple une épaisseur égale à environ 1 µm ;
- une couche en titane présentant par exemple une épaisseur égale à environ 10 nm ; et
- une couche en nitrure de titane présentant par exemple une épaisseur égale à environ 100 nm.

Les éléments de reprise de contact et/ou les pistes conductrices sont par exemple obtenus par dépôt successifs, par exemple par PVD, de couches en les matériaux précités, ces dépôts étant par exemple suivis d'une étape de structuration par photolithographie puis gravure.

Un avantage du procédé décrit ci-dessus en relation avec les figures 2A à 2E tient au fait qu'il permet de former la région centrale 111C du guide d'ondes 111 sur une surface plane. En particulier, lors de l'étape décrite en relation avec la figure 2B, une étape de planarisation, par exemple par CMP, est réalisée préalablement au dépôt de la couche isolante 115. La partie 103-2 de la couche isolante 103 est par exemple plus particulièrement planarisée par CMP avec arrêt sur la couche dans laquelle sont formées les électrodes de conduction 105A et 105B, ou la couche supérieure de l'empilement dans lequel sont formées les électrodes de conduction 105A et 105B, par exemple une couche en nitrure de titane. La surface d'arrêt lors de cette étape est par exemple supérieure à 35 %, par exemple de l'ordre de 50 %, de la surface du substrat de support 101. Cela facilite l'arrêt de l'opération de planarisation.

La personne du métier aurait pu envisager de former la région centrale 111C du guide d'ondes 111 au-dessus de la région 107 en matériau à changement de phase. Toutefois, une planarisation avec arrêt sur la région 107 en matériau à changement de phase s'avérerait complexe à réaliser, car le matériau à changement de phase de la région 107 risquerait d'être détérioré par des composés chimiques utilisés lors de l'opération de planarisation. Une solution pour pallier ce problème pourrait consister à prévoir, sur et en contact avec la face supérieure de la région 107 en matériau à changement de phase, une couche d'arrêt de gravure à retirer ultérieurement ou à prendre en compte dans le fonctionnement du commutateur 100. Toutefois, cela complexifierait la réalisation du commutateur 100. Par ailleurs, la surface de la région 107 en matériau à changement de phase étant par exemple inférieure à 1 % de la surface du substrat de support 101, l'arrêt de l'opération de planarisation ne pourrait pas être contrôlé avec précision. Des éléments non fonctionnels (« dummies », en anglais), par exemple des plots, en matériau à changement de phase pourraient être prévus afin d'augmenter la surface du matériau à changement de phase, par exemple pour obtenir des régions en matériau à changement de phase présentant une surface cumulée supérieure à 35 % de la surface du substrat de support 101. Toutefois, cela complexifierait grandement la conception et la réalisation du commutateur 100.

Bien que cela n'ait pas été détaillé, le commutateur 100 peut être intégré dans tout type de dispositif comprenant au moins un commutateur moyennant éventuellement des adaptations à la portée de la personne du métier à la lecture de la présente description. En particulier, la personne du métier est capable, à partir des indications de la présente description, d'intégrer des commutateurs du type du commutateur 100 dans des applications radiofréquence, par exemple dans des antennes reconfigurables à réseau transmetteur ou à réseau réflecteur.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Commutateur (100) à base d'un matériau à changement de phase à actionnement optique formé sur un substrat de support (101) et comprenant :
- une région (107) en ledit matériau à changement de phase reliant des première et deuxième électrodes de conduction (105A, 105B) du commutateur ; et
- un guide d'ondes (111) interposé entre le substrat de support et la région en ledit matériau à changement de phase et comportant une région centrale (111C) en un premier matériau présentant un premier indice optique entourée d'une région périphérique (103) en un deuxième matériau présentant un deuxième indice optique, inférieur au premier indice optique.

2. Commutateur (100) selon la revendication 1, dans lequel la région centrale (111C) du guide d'ondes (111) est séparée de la région (107) en ledit matériau à changement de phase par une distance inférieure ou égale à 100 nm, de préférence inférieure ou égale à 50 nm, plus préférentiellement égale à environ 20 nm.

3. Commutateur (100) selon la revendication 1 ou 2, dans lequel le guide d'ondes (111) comprend en outre un élément de couplage d'entrée (113) présentant une structure de Bragg comprenant des portions d'anneaux concentriques espacées de façon régulière.

4. Commutateur (100) selon la revendication 3, comprenant en outre une source laser (LS) destinée à illuminer l'élément de couplage (113) par un rayonnement laser présentant une longueur d'onde centrale égale à environ 915 nm.

5. Commutateur (100) selon la revendication 3 ou 4, dans lequel l'élément de couplage d'entrée (113) est séparé du substrat de support (101) par une distance égale à environ 1 500 nm, à plus ou moins 100 nm près.

6. Commutateur (100) selon l'une quelconque des revendications 1 à 5, dans lequel la région centrale (111C) du guide d'ondes (111) est séparée du substrat de support (101) par une distance égale à environ 1 500 nm, à plus ou moins 100 nm près.

7. Commutateur (100) selon l'une quelconque des revendications 1 à 6, comprenant en outre des premier et deuxième vias conducteurs (109A, 109B) s'étendant entre la région (107) en ledit matériau à changement de phase et les première et deuxième électrodes de conduction (105A, 105B), respectivement.

8. Commutateur (100) selon la revendication 7, dans lequel la région centrale (111C) du guide d'ondes (111) est séparée des premier et deuxième vias conducteurs (109A, 109B) par une distance supérieure ou égale à 0,3 µm.

9. Commutateur (100) selon l'une quelconque des revendications 1 à 8, dans lequel la région (107) en ledit matériau à changement de phase est revêtue d'une couche de passivation (117) .

10. Commutateur (100) selon l'une quelconque des revendications 1 à 9, dans lequel les régions centrale (111C) et périphérique (103) du guide d'ondes (111) sont respectivement en nitrure de silicium et en dioxyde de silicium.

11. Commutateur (100) selon l'une quelconque des revendications 1 à 10, dans lequel la région centrale (111C) du guide d'ondes (111) présente une hauteur égale à environ 300 nm et une largeur égale à environ 600 nm.

12. Procédé de fabrication d'un commutateur (100) à base d'un matériau à changement de phase à actionnement optique comprenant les étapes successives suivantes :
a) former, sur un substrat de support (101), des première et deuxième électrodes de conduction (105A, 105B) du commutateur ;
b) former, sur le substrat de support, un guide d'ondes (111) comportant une région centrale (111C) en un premier matériau présentant un premier indice optique entourée d'une région périphérique (103) en un deuxième matériau présentant un deuxième indice optique, inférieur au premier indice optique ; et
c) former, sur le substrat de support, une région (107) en ledit matériau à changement de phase reliant les première et deuxième électrodes de conduction du commutateur, le guide d'ondes étant interposé entre le substrat de support et la région en ledit matériau à changement de phase.
